# EUROPÄISCHE PATENTANMELDUNG

(11) **EP 0 992 824 A2**
(43) Veröffentlichungstag der Anmeldung: **12.04.2000**
(21) Anmeldenummer: 99119553.8
(22) Anmeldetag: 01.10.1999
(51) Int. Cl.: G02B 6/42

(54) **Mikrooptischer Baustein und Verfahren zu seiner Herstellung**

(30) Priorität: 02.10.1998 DE 19845484
(71) Anmelder: SIEMENS AKTIENGESELLSCHAFT, 80333 München (DE)
(72) Erfinder: Kuhn, Gerhard, Dr., 93096 Köfering (DE); Krug, Joachim, 93073 Neutraubling (DE); Weigert, Martin, 93152 Hardt (DE); Grötsch, Stefan, 93053 Regensburg (DE)

(57) **Zusammenfassung**

Die Erfindung betrifft ein Verfahren zur Herstellung eines mikrooptischen Bausteins mit einem Träger, einem Lichtsender, einem Umlenkmittel und einem Fokussierungsmittel.

Erfindungsgemäß zeichnet sich dieses Verfahren dadurch aus, daß der Lichtsender und das Umlenkmittel auf einer Seite (1a) eines Trägers (1) aufgebracht werden, daß auf einer der ersten Seite (1a) gegenüberliegenden zweiten Seite (1b) das Fokussierungsmittel (2) angeordnet wird, daß es von dem Lichtsender (4) emittierte Lichtstrahlung durch den Träger (1) in Richtung auf das Fokussierungsmittel (2) ablenken kann.

Die Erfindung betrifft ferner ein mit Hilfe des Verfahrens hergestelltes Bauteil.

## Beschreibung

Die Erfindung betrifft ein Verfahren zur Herstellung eines mikrooptischen Bausteins mit einem Träger, einem Lichtsender, einem Umlenkmittel und einem Fokussierungsmittel.

Die Erfindung betrifft ferner einen mikrooptischen Baustein mit einem Lichtsender, einem Umlenkmittel und einem Fokussierungsmittel.

Ein gattungsgemäßes Verfahren und ein gattungsgemäßer mikrooptischer Baustein sind in der europäischen Patentanmeldung 0 664 585 A1 offenbart.

Hierbei befinden sich der Lichtsender und zwei Ablenkmittel auf einem gemeinsamen Träger. Die Ablenkmittel sind dabei so beschaffen, daß sie von dem Lichtsender emittierte Strahlung senkrecht zu einer Seite des Trägers nach oben in Richtung auf ein oberhalb des Trägers angeordnetes Fokussierungsmittel umlenken.

Der Erfindung liegt die Aufgabe zugrunde, ein Verfahren zu schaffen, mit dem ein gattungsgemäßer Baustein auf möglichst einfache Weise hergestellt werden kann.

Erfindungsgemäß wird diese Aufgabe dadurch gelöst, daß der Lichtsender und das Umlenkmittel auf einer Seite eines Trägers aufgebracht werden, daß auf einer der ersten Seite gegenüberliegenden zweiten Seite das Fokussierungsmittel angeordnet wird und daß das Umlenkmittel so angeordnet wird, daß es von dem Lichtsender emittierte Lichtstrahlung durch den Träger in Richtung auf das Fokussierungsmittel ablenken kann.

Vorzugsweise ist der Träger dabei flächenförmig ausgebildet.

Die Erfindung sieht ferner vor, einen gattungsgemäßen Baustein so auszugestalten, daß der Lichtsender und das Umlenkmittel auf einer ersten Seite eines Trägers angeordnet sind und daß das Fokussierungsmittel einer der ersten Seite gegenüberliegenden zweiten Seite des Trägers zugewandt angeordnet ist und daß das Umlenkmittel so gestaltet ist, daß es von dem Lichtsender emittierte Lichtstrahlung durch den Träger in Richtung auf das Fokussierungsmittel ablenken kann.

Es ist besonders zweckmäßig, das Verfahren so durchzuführen, daß auf der ersten Seite zunächst der Lichtsender aufgebracht wird und daß dann in einem weiteren Verfahrensschritt das Umlenkmittel auf der ersten Seite aufgebracht wird.

Die Effizienz des Verfahrens kann dadurch weiter erhöht werden, daß vor dem Aufbringen des Umlenkmittels eine Untersuchung von Strahlungseigenschaften des Lichtsenders erfolgt. Durch die Untersuchung der Strahlungseigenschaften ist es möglich, Lichtsender, welche nicht geeignet sind, auszusortieren, so daß nur gut emittierende Lichtsender weiter verarbeitet werden. Außerdem ist es möglich, das Umlenkmittel in Abhängigkeit von den Strahlungseigenschaften des Lichtsenders aufzutragen. Hierdurch können Toleranzen bei der Herstellung des Lichtsenders ausgeglichen werden.

Eine besonders genaue Justierung und Abstimmung der optischen Komponenten wird dadurch erzielt, daß auf den Träger wenigstens eine Schicht aufgetragen wird, daß die Schicht anschließend so strukturiert wird, daß wenigstens ein Flächenbereich gebildet wird und daß anschließend der Lichtsender relativ zu dem Flächenbereich positioniert wird.

Eine weitere Verbesserung der Justierung läßt sich dadurch erzielen, daß die Strukturierung der Schicht so verläuft, daß der Flächenbereich wenigstens abschnittsweise gegenüber dem Fokussierungsmittel ausgerichtet ist.

Eine andere, gleichfalls vorteilhafte Ausführungsform des Verfahrens zeichnet sich dadurch aus, daß auf der ersten Seite zuerst das Umlenkmittel aufgebracht wird und daß dann in einem weiteren Verfahrensschritt der Lichtsender auf der ersten Seite aufgebracht wird.

Zweckmäßigerweise wird dabei das Verfahren so durchgeführt, daß vor dem Aufbringen des Lichtsenders eine Untersuchung von Umlenkeigenschaften des Umlenkmittels erfolgt.

Die Ergebnisse der Untersuchung der Umlenkeigenschaften des Umlenkmittels ermöglichen es, die Position des Lichtsenders an die Umlenkeigenschaften des Umlenkmittels anzupassen.

Ein besonders wirksamer Schutz des Lichtsenders läßt sich dadurch erreichen, daß zwischen den Lichtsender und das Umlenkmittel eine transparente Vergußmasse aufgebracht wird. Auf die transparente Vergußmasse wird in einem späteren, nicht dargestellten, Bearbeitungsschritt weiteres Material aufgebracht, das zum mechanischen Schutz des Bausteins dient. Die transparente Vergußmasse stellt sicher, daß auch bei einer zusätzlichen Umhüllung mit dem weiteren Material kein Strahlengang unterbrochen wird.

Eine vorteilhafte Ausführungsform des Bausteins zeichnet sich dadurch aus, daß das Fokussierungsmittel und der Träger räumlich voneinander getrennt sind.

Hierbei ist es zweckmäßig, daß das Fokussierungsmittel zu dem Umlenkmittel und dem Lichtsender justiert und fixiert ist.

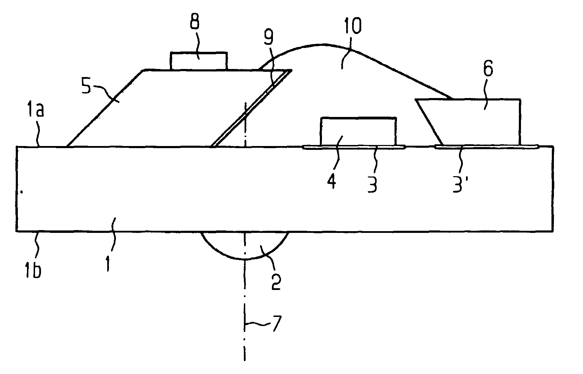

Weitere Vorteile, Besonderheiten und zweckmäßige Weiterbildungen der Erfindung ergeben sich aus den Unteransprüchen und der nachfolgenden Darstellung eines bevorzugten Ausführungsbeispiels anhand der Zeichnung.

Die Zeichnung zeigt einen Querschnitt durch einen mikrooptischen Baustein.

Auf einer Seite 1a eines Trägers 1 befinden sich ein Lichtsender 4 und ein Umlenkmittel 5. Auf einer gegenüberliegenden Seite 1b des Trägers 1 befindet sich ein Fokussierungsmittel 2.

In der dargestellten, besonders bevorzugten Bauform ist der Lichtsender 4 durch eine Laserdiode gebildet, das Umlenkmittel 5 durch einen Spiegel und das Fokussierungsmittel 2 durch eine in den Träger 1 integrierte Linse.

Es ist möglich, die einzelnen Bestandteile des Bausteins durch gleich wirkende Funktionselemente zu ersetzen. So kann beispielsweise anstelle der Laserdiode ein anderer Sender für Laserstrahlung oder für nicht kohärente Strahlung, beispielsweise eine Lumineszenzdiode, eingesetzt werden. Das Umlenkmittel 5 kann unabhängig von der Wahl des Lichtsenders 4 durch ein anderes geeignetes ersetzt werden, beispielsweise durch ein Prisma. Anstelle der Linse kann gleichfalls ein anderes Fokussierungsmittel 2 eingesetzt werden, beispielsweise ein optisches Gitter.

Das Umlenkmittel 5 ist so gestaltet, daß es von dem Lichtsender 4 ausgestrahltes Licht, insbesondere Laserlicht, durch den Träger 1 hindurch zu dem Fokussierungsmittel 2 umlenkt.

Eine besonders einfache Justierung ist dann möglich, wenn das Umlenkmittel 5 die Lichtstrahlen so ablenkt, daß sie im wesentlichen parallel zu einer optischen Achse 7 des Fokussierungsmittels 2 verlaufen. Besonders zweckmäßig ist es dabei, wenn die optische Achse des Fokussierungsmittels 2 im wesentlichen senkrecht zu dem Träger verläuft.

Der Träger 1 ist so beschaffen, daß ihn die von dem Lichtsender 4 emittierten und dem Umlenkmittel 5 umgelenkten Lichtstrahlen durchdringen können. Ein Einsatz von Silizium als Material für den Träger 1 ist dann möglich, wenn die Wellenlänge der Lichtstrahlung größer als 1,1 µm ist. Für dieses Licht ist Silizium transparent. Ein Einsatz von Silizium als Material für den Träger 1 ist zweckmäßig, weil Silizium prozeßtechnisch besonders einfach zu handhaben ist. Falls es wünschenswert ist, Lichtstrahlung mit einer kürzeren Wellenlänge als 1,1 µm einzusetzen, muß das Silizium durch ein anderes, für die jeweiligen Wellenlängen transparentes Material ersetzt werden.

Das Umlenkmittel 5 ist mit einer Spiegelschicht 9 versehen.

Für die besonders vorteilhafte Ausgestaltung des Bausteins für bidirektionale Datenübertragung enthält der Baustein zusätzlich einen Lichtempfänger 8, der beispielsweise durch eine Photodiode gebildet ist. Die Spiegelbeschichtung 9 enthält eine aus Platzgründen nicht dargestellte Filterschicht, die so beschaffen ist, daß Licht mit der Wellenlänge des Lichtsenders 4 reflektiert wird, während Licht einer anderen Wellenlänge, das von einem nicht dargestellten Lichtsender emittiert wird, nicht reflektiert wird.

Hierdurch gelangt Licht durch das Umlenkmittel 5 hindurch, das in Gegenrichtung zu den den Träger 1 durchdringenden, von dem Lichtsender 4 ausgestrahlten und von dem Umlenkmittel 5 abgelenkten Lichtstrahlen verläuft. Die Lichtstrahlung mit der anderen Wellenlänge wird anschließend von dem Lichtempfänger 8 detektiert.

Der dargestellte Baustein wird vorzugsweise wie folgt hergestellt: Eine Scheibe aus einem ätzbaren Material, vorzugsweise einem Halbleitermaterial, insbesondere Silizium, wird im Bereich einer Oberfläche so geätzt, daß soviel Material entfernt wird, daß nur eine Linsenkalotte über die Seite 1b übersteht. Auf diese Weise wurde eine integrierte Linse geschaffen, die in dem fertigen Baustein das Umlenkmittel bildet.

Anschließend werden auf der gegenüberliegenden Seite 1a des Trägers 1 Flächenbereiche 3 und 3' erzeugt. Bei den Flächenbereichen 3 und 3' handelt es sich zum Beispiel um Metallisierungsflächen.

Die Flächenbereiche 3 und 3' werden vorzugsweise dadurch erzeugt, daß zunächst nach einem der aus der Halbleitertechnologie bekannten Schichterzeugungsverfahren, wie der Gasphasenabscheidung (CVD-Verfahren, CVD = Chemical Vapour Deposition) oder der Kathodenzerstäubung (Sputtern) wenigstens eine Schicht erzeugt wird. Das bevorzugte Schichtauftragungsverfahren ist die Gasphasenabscheidung.

Anschließend wird die Schicht strukturiert. Die Strukturierung erfolgt vorzugsweise mittels Photolitographie.

Die Position des Flächenbereiches 3 zu dem Fokussierungsmittel 2 kann sehr genau festgelegt werden, weil durch den Einsatz der Photolithographie die Strukturierung des Flächenbereiches 3 besonders exakt erfolgen kann.

Eine weitere Verbesserung der Justierung läßt sich dadurch erzielen, daß Lage und/oder Abbildungseigenschaften der Linsenkalotte erfaßt werden und daß die Anordnung des Lichtsenders 4 in Abhängigkeit von der Lage und/oder den Abbildungseigenschaften der Linsenkalotte erfolgt.

Bei dem bevorzugten Einsatz von Photolitographie für die Strukturierung des Flächenbereiches 3 wird eine Vorder- zu Rückseitenlitographie eingesetzt, bei der die Justierung des Photolitograhievorgangs auf der ersten Seite 1a in Abhängigkeit von der Lage und/oder den Abbildungseigenschaften des auf der zweiten Seite 1b befindlichen Fokussierungsmittels 2 erfolgt.

Gemeinsam mit dem Flächenbereich 3 wird ein weiterer Flächenbereich 3' erzeugt, auf den in einem späteren Prozeßschritt die Monitordiode 6 aufgebracht wird.

Der Lichtsender 4 wird zu dem Flächenbereich 3 justiert, damit seine Position besonders genau festgelegt wird.

Beispielsweise wird im Anschluß an die Positionierung des Lichtsenders 4 das Umlenkmittel 5 aufgebracht, so daß Fokus- und Schielwinkel beeinflußt werden können.

Im Anschluß an das Aufbringen des Umlenkmittels 5, des Lichtsenders 4 und der Monitordiode 6 wird eine transparente Vergußmasse 10 so vergossen, daß sie den Lichtsender 4 und Zwischenräume zwischen dem Lichtsender 4 und der Monitordiode 6 vollständig bedeckt. Hierdurch wird ein optischer Weg auch bei einer nachfolgenden Auftragung von opaken Vergußmaterialien sichergestellt.

## Patentansprüche

1. Verfahren zur Herstellung eines mikrooptischen Bausteins mit einem Lichtsender (4), einem Umlenkmittel(5) und einem Fokussierungsmittel (2), **dadurch gekennzeichnet,** daß der Lichtsender (4) und das Umlenkmittel (5) auf einer Seite (1a) eines Trägers (1) aufgebracht werden, daß auf einer der ersten Seite (1a) gegenüberliegenden zweiten Seite (1b) das Fokussierungsmittel (2) angeordnet wird und daß das Umlenkmittel (5) so angeordnet wird, daß es von dem Lichtsender (4) emittierte Lichtstrahlung durch den Träger (1) in Richtung auf das Fokussierungsmittel (2) ablenken kann.

2. Verfahren nach Anspruch 1, **dadurch gekennzeichnet,** daß auf der ersten Seite (1a) zuerst der Lichtsender (4) angeordnet wird und daß in einem weiteren Verfahrensschritt das Umlenkmittel (5) auf der ersten Seite (1a) angeordnet wird.

3. Verfahren nach Anspruch 2**, dadurch gekennzeichnet,** daß vor dem Anordnen des Umlenkmittels (5) eine Untersuchung von Strahlungseigenschaften des Lichtsenders (4) erfolgt.

4. Verfahren nach einem der Ansprüche 1 bis 3, **dadurch gekennzeichnet,** daß auf den Träger (1) wenigstens eine Schicht aufgetragen wird, daß die Schicht anschließend so strukturiert wird, daß wenigstens ein Flächenbereich (3) gebildet wird und daß anschließend der Lichtsender (4) relativ zu dem Flächenbereich (3) positioniert wird.

5. Verfahren nach Anspruch 4, **dadurch gekennzeichnet,** daß die Strukturierung der Schicht so verläuft, daß der Flächenbereich (3) wenigstens abschnittsweise gegenüber dem Fokussierungsmittel (2) ausgerichtet ist.

6. Verfahren nach Anspruch 1, **dadurch gekennzeichnet,** daß auf der ersten Seite (1a) zuerst das Umlenkmittel (5) angeordnet wird und daß dann in einem weiteren Verfahrensschritt der Lichtsender (4) auf der ersten Seite (1a) angeordnet wird.

7. Verfahren nach Anspruch 6, **dadurch gekennzeichnet,** daß vor dem Anordnen des Lichtsenders (4) eine Untersuchung von Umlenkeigenschaften des Umlenkmittels (5) erfolgt.

8. Verfahren nach einem der Ansprüche 1 bis 7, **dadurch gekennzeichnet,** daß das Fokussierungsmittel (2) in den Träger (1) integiert wird.

9. Verfahren nach Anspruch 8, **dadurch gekennzeichnet,** daß das Fokussierungsmittel (2) dadurch in den Träger (1) integiert wird, daß aus einem Grundkörper für den Träger (1) soviel Material entfernt wird, daß nur eine Linsenkalotte im Bereich der zweiten Seite (1b) übersteht.

10. Verfahren nach Anspruch 9**, dadurch gekennzeichnet,** daß Lage und/oder Abbildungseigenschaften der Linsenkalotte erfaßt werden und daß die Anordnung des Lichtsenders (4) in Abhängigkeit von der Lage und/oder den Abbildungseigenschaften der Linsenkalotte erfolgt.

11. Verfahren nach einem der Ansprüche 1 bis 11, **dadurch gekennzeichnet,** daß das Umlenkmittel (5) derart wellenlängenselektiv gestaltet wird, daß es von dem Lichtsender(4) emittiertes Licht anders umlenkt als Licht einer anderen Wellenlänge.

12. Verfahren nach einem der Ansprüche 1 bis 11, **dadurch gekennzeichnet,** daß zwischen den Lichtsender (4) und das Umlenkmittel (5) eine transparente Vergußmasse (10) aufgebracht wird.

13. Mikrooptischer Baustein mit einem Lichtsender (4), einem Umlenkmittel (5) und einem Fokussierungsmittel (2), **dadurch gekennzeichnet,** daß der Lichtsender (4) und das Umlenkmittel (5) auf einer ersten Seite (1a) eines Trägers (1) angeordnet sind und daß das Fokussierungsmittel (2) einer der ersten Seite (1a) gegenüberliegenden zweiten Seite (1b) des Trägers (1) zugewandt angeordnet ist und daß das Umlenkmittel (5) so gestaltet ist, daß es von dem Lichtsender (4) emittierte Lichtstrahlung durch den Träger in Richtung auf das Fokussierungsmittel (2) ablenken kann.

14. Mikrooptischer Baustein nach Anspruch 13, **dadurch gekennzeichnet,** daß das Umlenkmittel (5) derart wellenlängenselektiv gestaltet ist, daß es von dem Lichtsender(4) emittiertes Licht anders umlenkt als Licht einer anderen Wellenlänge.

15. Mikrooptischer Baustein nach Anspruch 14, **dadurch gekennzeichnet,** daß das Licht anderer Wellenlänge durch das Umlenkmittel (5) nicht abgelenkt wird.

16. Mikrooptischer Baustein nach einem der Ansprüche 13 bis 15, **dadurch gekennzeichnet,** daß er einen Lichtempfänger (8) enthält.

17. Mikrooptischer Baustein nach einem der Ansprüche 13 bis 16, **dadurch gekennzeichnet,** daß das Fokussierungsmittel (2) und der Träger (1) räumlich voneinander getrennt sind.

18. Mikrooptischer Baustein nach Anspruch 17, **dadurch gekennzeichnet,** daß das Fokussierungsmittel (2) zu dem Umlenkmittel (5) und dem Lichtsender (4) justiert und fixiert ist.
